# EUROPÄISCHE PATENTSCHRIFT

(11) **EP 2 954 761 B1**
(45) Veröffentlichungstag und Bekanntmachung des Hinweises auf die Patenterteilung: **27.03.2019**
(21) Anmeldenummer: 14706256.6
(22) Anmeldetag: 07.01.2014
(51) Int. Cl.: H05K 1/02, F21S 41/147, F21S 41/19, F21S 41/39, F21S 45/47, H05K 1/11, H05K 3/00

(54) **VERFAHREN ZUM HERSTELLEN EINER LEUCHTEINHEIT**
METHOD FOR PRODUCING A HEADLIGHT ASSEMBLY
PROCÉDÉ POUR FABRIQUER UNE UNITÉ LUMINESCENTE

(30) Priorität: 07.02.2013 AT 982013
(43) Veröffentlichungstag der Anmeldung: 16.12.2015
(73) Patentinhaber: ZKW Group GmbH, 3250 Wieselburg (AT)
(72) Erfinder: BAUER, Friedrich, A-3252 Bergland (AT); BIESENBERGER, Martin, A-3680 Persenbeug (AT)
(74) Vertreter: Patentanwaltskanzlei Matschnig & Forsthuber OG
(86) Internationale Anmeldenummer: PCT/AT2014/050001
(87) Internationale Veröffentlichungsnummer: WO 2014/121312

(56) Entgegenhaltungen:
- EP-A1- 2 039 990
- US-A1- 2002 053 878
- US-A1- 2008 316 759
- US-A1- 2011 242 805

## Beschreibung

Die Erfindung betrifft ein Verfahren zum Herstellen einer Leuchteinheit eines Fahrzeugscheinwerfers sowie eine nach diesem Verfahren hergestellte Leuchteinheit.
Moderne Fahrzeugscheinwerfer bieten nicht nur verschiedene aufwendige und leistungsfähige Lichtfunktionen, sondern sind zunehmend in das Design der jeweiligen Fahrzeuge integriert und hinsichtlich des Luftwiderstandes des Fahrzeugs und auch hinsichtlich sicherheitsrelevanter Aspekte, wie beispielsweise Fußgängerschutz, optimiert. Mit diesen an sich wünschenswerten Eigenschaften und Funktionen moderner Fahrzeugscheinwerfer gehen jedoch Schwierigkeiten bei der Standardisierung der entsprechenden Bauteile einher, sodass es zunehmend schwierig wird, größere Stückzahlen der Bauteile und damit Skaleneffekte bei den Kosten zu erreichen. Dies ist insbesondere für Fahrzeuge in mittleren bis niedrigen Preissegmenten nachteilig.
In US 2008/0316759 A1 ist ein Scheinwerfersystem mit mehreren Lichtquellen und diesen jeweils zugeordneten Linsensystemen offenbart, von denen ein erstes eine breite Lichtverteilung und ein zweites einen Spot erzeugt. EP 2039 990 A1 offenbart ein Trägerelement für LEDs mit variabler Orientierung einer LED-Einheit. Andere Anordnungen, die LEDs als Lichtquellen haben, sind in US 2002/0053878 A1 sowie US 2011/0242805 A1 beschrieben.
Es ist daher Aufgabe der vorliegenden Erfindung, ein Verfahren zum Herstellen einer Leuchteinheit eines Fahrzeugscheinwerfers anzugeben, welches bei Verwendung von standardisierten Bauteilen größtmögliche Flexibilität hinsichtlich der mit diesen Bauteilen realisierbaren Lichtfunktionen gestattet, wobei die Montage der Leuchteinheiten und der entsprechenden Bauteile einfach und fehlerfrei durchführbar sein soll.
Zur Lösung dieser Aufgabe ist ein Verfahren der eingangs genannten Art gemäß der vorliegenden Erfindung durch die folgenden Schritte gekennzeichnet:
Bereitstellen einer Platine mit einer Mehrzahl von gleichartigen Gruppen von Kontaktpads für die Kontaktierung von LEDs,
Auswählen einer gewünschten Lichtfunktion, beispielweise Tagfahrlicht, Abblendlicht oder Fernlicht, für die jeweilige Gruppe von Kontaktpads,
Bestücken von LEDs auf Kontaktpads der Gruppen, wobei nur diejenigen Kontaktpads in den einzelnen Gruppen mit LEDs bestückt werden, welche entsprechend der gewünschten Lichtfunktion der jeweiligen Gruppe ausgewählt sind, und
Bereitstellen von Festlegungsmitteln für Reflektoren auf der Platine, wobei die Festlegungsmittel jeweils für einen an die Lichtfunktion der jeweiligen Gruppe angepassten Reflektor spezifisch sind.
Die vorliegende Erfindung gestattet es somit, eine große Anzahl von Platinen unabhängig von den mit der Erfindung zu erzielenden Lichtfunktionen zukünftiger Scheinwerfer herzustellen, wobei diese Platinen eine Vielzahl von Kontaktpads in gleichartigen Gruppen aufweisen. Je nachdem, welche Lichtfunktionen mit dieser standardisierten Platine für die Scheinwerfer eines Fahrzeugs zur Verfügung gestellt werden sollen, werden ausgewählte Kontaktpads mit LEDs bestückt, wobei im Normalfall jeweils eine Gruppe von Kontaktpads einer Lichtfunktion, z.B. Tagfahrlicht, Abblendlicht, Fernlicht, zugeordnet ist. Um nun gemäß der oben formulierten Aufgabe der Erfindung nicht nur die erhöhte Flexibilität bei Verwendung einer standardisierten Platine zu gewährleisten, ist es als weiterer Schritt des erfindungsgemäßen Verfahrens vorgesehen, dass auf der standardisierten Platine Festlegungsmittel für die an die jeweiligen Lichtfunktionen der einzelnen Gruppen angepassten Reflektoren bereitgestellt werden, wobei die Festlegungsmittel aufgrund ihrer Geometrie für die an die Lichtfunktion der jeweiligen Gruppe angepassten Reflektoren spezifisch sind. Das bedeutet, dass die bei erfindungsgemäßen Verfahren zum Einsatz gelangenden Reflektoren entsprechend ihrer Anpassung an die jeweiligen Lichtfunktionen spezifische Gegenstücke zu den Festlegungsmitteln aufweisen, um ein fehlerfreies Zusammenbauen der Leuchteinheit gemäß der vorliegenden Erfindung zu gewährleisten.

Mit der vorliegenden Erfindung ist es daher möglich, standardisierte Platinen mit einer Vielzahl von Kontaktpads für verschiedene Lichtfunktionen herzustellen, wobei bei der Konfektionierung nur diejenigen Kontaktpads in den einzelnen Gruppen mit LEDs besetzt werden, die für die jeweilige Lichtfunktion vonnöten sind und die Bereitstellung von Festlegungsmitteln, die für die Lichtfunktion geeigneten Reflektoren spezifisch, d.h. codierend sind, so erfolgt, dass auch bei einer kostengünstigen Massenproduktion von Fahrzeugscheinwerfern fehlerhafte Paarungen von LEDs und Reflektor ausgeschlossen werden können. Weiters gestattet es die Erfindung, mit gleichartigen Platinen sowohl linke und rechte Scheinwerfer zu realisieren. Linke und rechte Scheinwerfer eines Fahrzeugs sind in der Regel nicht einfach spiegelverkehrt aufgebaut, da die meisten Zulieferteile nicht spiegelbildlich erhältlich sind und daher eine entsprechende Konfiguration des Lichtbilds erforderlich ist.

Gemäß einer bevorzugten Ausführungsform der vorliegenden Erfindung werden die Festlegungsmittel als Bohrungen in der Platine ausgebildet, die geeignet sind, mit entsprechenden Fixierstiften an den Reflektoren zusammenzuwirken. Dies stellt eine besonders einfache Ergänzung der vorliegenden Erfindung dar, da das Ausführen von einfachen Bohrungen in einer Platine mit geringem Aufwand möglich ist und gleichzeitig eine eindeutige Codierung der Festlegungsmittel zu den Fixierstiften an den Reflektoren ermöglicht.

Es ist dem Fachmann bekannt, dass beim Bestücken von LEDs auf Kontaktpads gewisse Fertigungstoleranzen hinsichtlich der genauen Position auftreten, die durch entsprechende Ausrichtung der jeweiligen Reflektoren zu den Lichtquellen bzw. LEDs präzise ausgeglichen werden müssen. Das erfindungsgemäße Verfahren ist daher gemäß einer bevorzugten Ausführungsform dahingehend weitergebildet, dass die Position der Festlegungsmittel relativ zur jeweiligen Gruppe anhand der Positionen der LEDs nach dem Bestücken bestimmt wird. Es wird somit erst nach dem Bestücken der LEDs auf die Kontaktpads deren genaue Position bestimmt und die Festlegungsmittel für die Reflektoren werden anhand dieser Positionen platziert.

Gemäß einer bevorzugten Ausführungsform der vorliegenden Erfindung wird die Platine auf einem Träger mit einem Kühlkörper und einer Steuerelektronik für die LEDs festgelegt. Das dadurch erhaltene Modul kann platzsparend an die jeweiligen Produktionsbetriebe geliefert werden, woraufhin die Endmontage der Reflektoren und in weiterer Folge der Fahrzeugscheinwerfer erfolgen kann.

Die erfindungsgemäße Leuchteinheit ist nach dem soeben beschriebene Verfahren hergestellt und zeichnet sich durch besonders geringe Herstellungskosten aus.

Eine besonders flexible und daher bevorzugte Leuchteinheit wird im Zusammenhang mit der vorliegenden Erfindung erhalten, wenn die Kontaktpads der Gruppen einzeln ansteuerbar sind. Auf diese Weise kann zusätzlich zur Flexibilität hinsichtlich der Bestückung das Lichtbild durch gezieltes Einschalten und Ausschalten einzelner LEDs beeinflusst werden, ohne dass die Platine selbst entsprechend verändert werden muss.

Die Erfindung wird nachfolgend anhand eines in den Zeichnungen schematisch dargestellten Ausführungsbeispiels näher erläutert. In diesen zeigen:
Fig. 1 eine perspektivische Ansicht der bei dem erfindungsgemäßen Verfahren zum Einsatz gelangenden Platine mit Träger und Reflektoren, wobei die Reflektoren nicht auf die Platine aufgesetzt sind, und
Fig. 2 eine Ansicht gemäß Fig. 1 mit aufgesetzten Reflektoren.

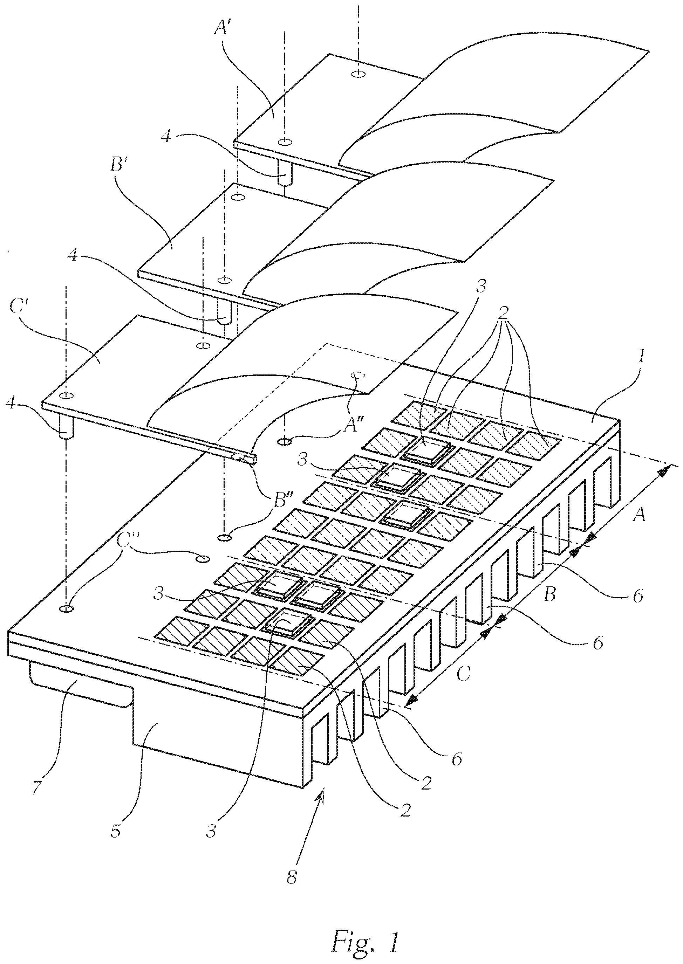

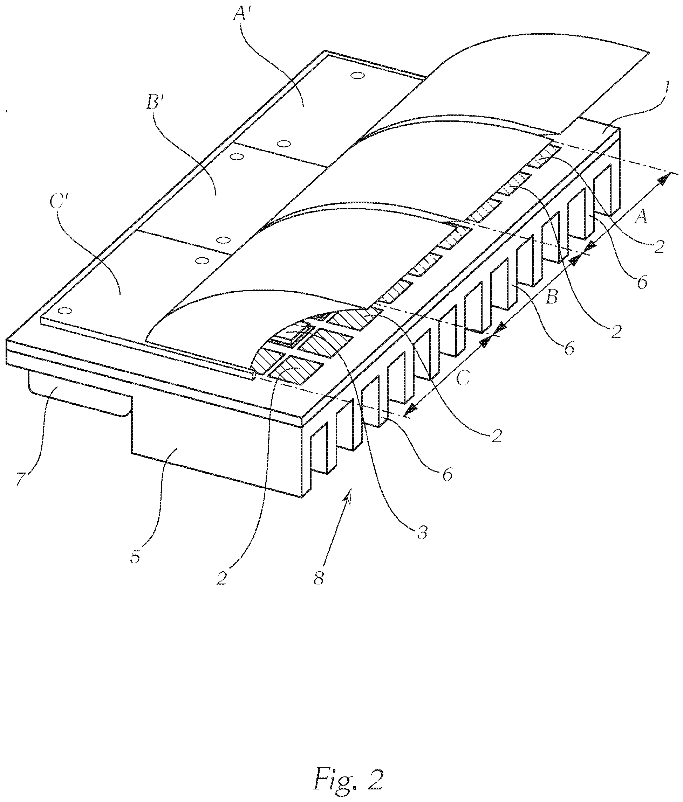

In Fig. 1 ist mit 1 eine Platine bezeichnet, die drei einander gleichende Gruppen A, B und C von Kontaktpads 2 aufweist. Wie in Fig. 1 deutlich zu erkennen ist, kann die Bestückung der Kontaktpads 2 der einzelnen Gruppen A, B und C mit LEDs 3 unterschiedlich erfolgen, wobei in Gruppe B beispielsweise eine Taglichtfunktion, in Gruppe A eine Abblendlichtfunktion und in Gruppe C eine Fernlichtfunktion realisiert werden kann. Entsprechend der verschiedenen Bestückungen der LEDs in den einzelnen Gruppen A, B und C und den damit zusammenhängenden, unterschiedlichen Lichtfunktionen müssen auch an diese speziellen Lichtfunktionen angepasste Reflektoren A', B' und C' verbaut werden. Um hier, wie oben beschrieben, Verwechslungen auszuschließen, werden nun Festlegungsmittel A", B" und C" für Reflektoren A', B' und C' auf der Platine 1 bereitgestellt, die in ihrer Geometrie bzw. in ihrer Anordnung der Geometrie bzw. Anordnung der Fixierstifte 4 der Reflektoren A', B' und C' entsprechen, sodass beispielsweise der Reflektor C' nur in die Festlegungsmittel C", die im vorliegenden Fall als Bohrungen ausgebildet sind, eingesetzt werden kann. Dadurch wird eine falsche Paarung zwischen der Art der Bestückung der LEDs 3 in Gruppe C auf der Platine 1 und dem Reflektor sicher vermieden. Mit 5 ist ein Träger bezeichnet, auf dem die Platine 1 festgelegt wird. Der Träger 5 weist einen Kühlkörper 8 in Form einer Reihe von Kühlrippen 6 und eine nicht näher dargestellte Steuerelektronik 7 für die LEDs 3 auf. In Fig. 2 ist nun zu erkennen, dass die Reflektoren A', B' und C' in die Festlegungsmittel A", B" und C" eingesetzt werden und somit das durch die LEDs 3 abgestrahlte Licht entsprechend bündeln und lenken können. Auf diese Weise lässt sich eine Leuchteinheit eines Fahrzeugscheinwerfers auf einer standardisierten Platine 1 herstellen, wobei eine erhöhte Flexibilität hinsichtlich der Lichtfunktionen gegeben ist und gleichzeitig Fehler beim Anbau der für die jeweiligen Lichtfunktionen notwendigen Reflektoren vermieden werden können.

## Patentansprüche

1. Verfahren zum Herstellen einer Leuchteinheit eines Fahrzeugscheinwerfers umfassend die folgenden Schritte:
Bereitstellen einer Platine (1) mit einer Mehrzahl von gleichartigen Gruppen (A, B, C) von Kontaktpads (2) für die Kontaktierung von LEDs (3),
Auswählen einer gewünschten Lichtfunktion, beispielweise Tagfahrlicht, Abblendlicht oder Fernlicht, für die jeweilige Gruppe (A, B, C) von Kontaktpads (2),
Bestücken von LEDs (3) auf Kontaktpads (2) der Gruppen (A, B, C), wobei nur diejenigen Kontaktpads (2) in den einzelnen Gruppen (A, B, C) mit LEDs (3) bestückt werden, welche entsprechend der gewünschten Lichtfunktion der jeweiligen Gruppe (A, B, C) ausgewählt sind, und
Bereitstellen von Festlegungsmitteln (A", B", C") für Reflektoren (A', B', C') auf der Platine (1), wobei die Festlegungsmittel (A", B", C") jeweils für einen an die gewählte Lichtfunktion der jeweiligen Gruppe (A, B, C) angepassten Reflektor (A', B', C') spezifisch sind.

2. Verfahren nach Anspruch 1, **dadurch gekennzeichnet, dass** die Festlegungsmittel (A", B", C") als Bohrungen in der Platine (1) ausgebildet werden, die geeignet sind, mit entsprechenden Fixierstiften (4) an den Reflektoren (A', B', C') zusammenzuwirken.

3. Verfahren nach Anspruch 1 oder 2, **dadurch gekennzeichnet, dass** die Position der Festlegungsmittel (A", B", C") relativ zur jeweiligen Gruppe (A, B, C) anhand der Positionen der LEDs (3) nach dem Bestücken bestimmt wird.

4. Verfahren nach einem der Ansprüche 1 bis 3, **dadurch gekennzeichnet, dass** die Platine (1) auf einem Träger (5) mit einem Kühlkörper (8) und einer Steuerelektronik (7) für die LEDs (3) festgelegt wird.

5. Leuchteinheit hergestellt nach einem Verfahren nach einem der Ansprüche 1 bis 4, umfassend eine Platine (1) mit einer Mehrzahl von gleichartigen Gruppen (A, B, C) von Kontaktpads (2) für die Kontaktierung von LEDs (3), wobei je nach ausgewählter Lichtfunktion der jeweiligen Gruppe (A, B, C) nur die entsprechend erforderlichen Kontaktpads (2) in den einzelnen Gruppen (A, B, C) mit LEDs (3) bestückt sind, sowie weiterhin umfassend Festlegungsmittel (A", B", C") für Reflektoren (A', B', C') auf der Platine (1), wobei die Festlegungsmittel (A", B", C") jeweils für einen an die gewählte Lichtfunktion der jeweiligen Gruppe (A, B, C) angepassten Reflektor (A', B', C') spezifisch sind.

6. Leuchteinheit nach Anspruch 5, **dadurch gekennzeichnet, dass** die Kontaktpads (2) der Gruppen (A, B, C) einzeln ansteuerbar sind.

## Claims

1. A method for the manufacture of a lighting unit of a vehicle headlamp, comprising the following steps:
provision of a circuit board (1) with a multiplicity of similar groups (A, B, C) of contact pads (2) for the establishment of contact with LEDs (3),
selection of a desired lighting function, for example, daytime running light, low beam or high beam, for the respective group (A, B, C) of contact pads (2),
fitting of LEDs (3) on contact pads (2) of the groups (A, B, C), wherein
only those contact pads (2) in the individual groups (A, B, C) are fitted with LEDs (3), which are selected in accordance with the desired lighting function of the respective group (A, B, C), and
provision of fixing means (A", B", C") for reflectors (A', B', C') on the circuit board (1), wherein
the fixing means (A", B", C") are in each case, specific to a reflector (A', B', C'), matched to the selected lighting function of the respective group (A, B, C).

2. The method in accordance with claim 1, **characterised in that** the fixing means (A", B", C") are designed as holes in the circuit board (1), which are suited for interaction with corresponding fixing pins (4) on the reflectors (A', B', C').

3. The method in accordance with claim 1 or 2, **characterised in that** the position of the fixing means (A", B", C") relative to the respective group (A, B, C) is determined on the basis of the positions of the LEDs (3) after fitting.

4. The method in accordance with one of the claims 1 to 3, **characterised in that** the circuit board (1) is fixed on a support (5) with a cooling body (8) and control electronics (7) for the LEDs (3).

5. A lighting unit manufactured in accordance with a method in accordance with one of the claims 1 to 4,
comprising a circuit board (1) with a multiplicity of similar groups (A, B, C) of contact pads (2) for the establishment of contact with LEDs (3), wherein
depending on the selected lighting function of the respective group (A, B, C), only the correspondingly required contact pads (2) in the individual groups (A, B, C) are fitted with LEDs (3),
and further comprising fixing means (A", B", C") for reflectors (A', B', C') on the circuit board (1), wherein
the fixing means (A", B", C") are in each case, specific to a reflector (A', B', C'), matched to the selected lighting function of the respective group (A, B, C).

6. The lighting unit in accordance with claim 5, **characterised in that** the contact pads (2) of the groups (A, B, C) can be individually activated.

## Revendications

1. Procédé de fabrication d'une unité d'éclairage d'un phare de véhicule, comportant les étapes suivantes consistant à :
- fournir une carte à circuits imprimés (1) ayant une pluralité de groupes similaires (A, B, C) de plages de contact (2) pour la mise en contact de diodes électroluminescentes (LED) (3) ;
- sélectionner une fonction d'éclairage souhaitée, par exemple feux de position, feux de croisement ou feux de route, pour le groupe respectif (A, B, C) de plages de contact (2) ;
- monter des LED (3) sur des plages de contact (2) des groupes (A, B, C), où seules les plages de contact (2) dans les groupes individuels (A, B, C) sont équipées de LED (3), lesquelles sont choisies conformément à la fonction d'éclairage souhaitée du groupe respectif (A, B, C) ; et
- fournir des moyens de fixation (A", B", C") pour des réflecteurs (A', B', C') sur la carte à circuits imprimés (1), les moyens de fixation (A", B", C") étant spécifiques à chaque fois pour un réflecteur (A', B', C') adapté à la fonction d'éclairage sélectionnée du groupe respectif (A, B, C).

2. Procédé selon la revendication 1, **caractérisé par le fait que** les moyens de fixation (A", B", C") sont réalisés en tant qu'alésages dans la carte à circuits imprimés (1), qui sont appropriés pour coopérer avec des broches de fixation correspondantes (4) sur les réflecteurs (A', B', C').

3. Procédé selon l'une des revendications 1 ou 2, **caractérisé par le fait que** la position des moyens de fixation (A", B", C") par rapport au groupe respectif (A, B, C) est déterminée sur la base des positions des LED (3) après le montage.

4. Procédé selon l'une des revendications 1 à 3, **caractérisé par le fait que** la carte à circuits imprimés (1) est fixée sur un support (5) ayant un dissipateur thermique (8) et une électronique de commande (7) pour les LED (3).

5. Unité d'éclairage obtenue par un procédé selon l'une des revendications 1 à 4, comportant une carte à circuits imprimés (1) ayant une pluralité de groupes similaires (A, B, C) de plages de contact (2) pour la mise en contact de LED (3), où à chaque fois selon une fonction d'éclairage sélectionnée du groupe respectif (A, B, C), seules les plages de contact (2) nécessaires en conséquence dans les groupes individuels (A, B, C) sont équipées de LED (3), et comportant également des moyens de fixation (A", B", C") pour des réflecteurs (A', B', C') sur la carte à circuits imprimés (1), les moyens de fixation (A", B", C") étant spécifiques à chaque fois pour un réflecteur (A', B', C') adapté à la fonction d'éclairage sélectionnée du groupe respectif (A, B, C).

6. Unité d'éclairage selon la revendication 5, **caractérisée par le fait que** les plages de contact (2) des groupes (A, B, C) sont aptes à être commandées individuellement.
